(19) Europäisches Patentamt
European Patent Office
Office européen des brevets

(11) **EP 2 365 282 B1**

(12) **FASCICULE DE BREVET EUROPEEN**

(45) Date de publication et mention
de la délivrance du brevet:
**12.11.2014 Bulletin 2014/46**

(21) Numéro de dépôt: **11157134.5**

(22) Date de dépôt: **07.03.2011**

(51) Int Cl.:
*G01C 19/56* (2012.01)   *H03H 9/24* (2006.01)

(54) **Procédé et dispositif de suppression d'hysteresis de résonateurs par résonances simultanées**

Verfahren und Vorrichtung zur Unterdrückung von Hysterese der Resonatoren durch simultane Resonanzen

Method and device for suppressing resonator hysteresis by simultaneous resonance

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **11.03.2010 FR 1051750**

(43) Date de publication de la demande:
**14.09.2011 Bulletin 2011/37**

(73) Titulaire: **Commissariat à l'Énergie Atomique et aux Énergies Alternatives 75015 Paris (FR)**

(72) Inventeurs:
• **HENTZ, Sébastien**
  **38000, GRENOBLE (FR)**
• **KACEM, Najib**
  **74100 Annemasse (FR)**

(74) Mandataire: **Ilgart, Jean-Christophe BREVALEX 95, rue d'Amsterdam 75378 Paris Cedex 8 (FR)**

(56) Documents cités:
• **KACEM AND AL: "Nonlinear dynamics of nanomechanical beam resonators: improving the performance of NEMS-based sensors", NANOTECHNOLOGY, vol. 20, no. 17, 16 juin 2009 (2009-06-16), XP002615758, DOI: 10.1088/0957-4484/20/27/275501**
• **L.C. SHAO AND AL: "The nonlinearity cancellation phenomenon in micromechanical resonators", JOURNAL OF MICROMECHANICS AND MICROENGINEERING, vol. 18, no. 6, 6 mai 2008 (2008-05-06), XP002615759, DOI: 10.1088/0960-1317/18/6/065014**
• **J. JUILLARD AND AL: "Large amplitude dynamics of micro-/nanomechanical resonators actuated with electrostatic pulses", JOURNAL OF APPLIED PHYSICS, vol. 107, no. 1, 7 janvier 2010 (2010-01-07), XP002615760, DOI: 10.1063/1.3277022**

Il est rappelé que: Dans un délai de neuf mois à compter de la publication de la mention de la délivrance du brevet européen au Bulletin européen des brevets, toute personne peut faire opposition à ce brevet auprès de l'Office européen des brevets, conformément au règlement d'exécution. L'opposition n'est réputée formée qu'après le paiement de la taxe d'opposition. (Art. 99(1) Convention sur le brevet européen).

**Description**

## DOMAINE TECHNIQUE ET ART ANTÉRIEUR

L'invention concerne le domaine des résonateurs, notamment de type MEMS ou NEMS.

Les applications concernées peuvent être des capteurs résonants, par exemple inertiels, ou des capteurs de gaz ou de masse.

Une autre application est celle de la réalisation d'oscillateurs pour base de temps.

Dans tous ces domaines, les performances (résolution en accélération, concentration, masse, ou stabilité de la fréquence générée) sont proportionnelles au rapport signal sur bruit, qu'on peut exprimer, par exemple en déplacement mécanique du résonateur, par $SNR = \dfrac{P_0}{S_x}$ où $S_x$ est la densité spectrale de bruit et $P_0$ la puissance de la porteuse,

soit $P_0 = \dfrac{1}{2}A^2$, où A est l'amplitude de vibration du résonateur mécanique.

Pour améliorer les performances du résonateur, on cherche à obtenir l'amplitude d'actionnement A du résonateur la plus grande possible.

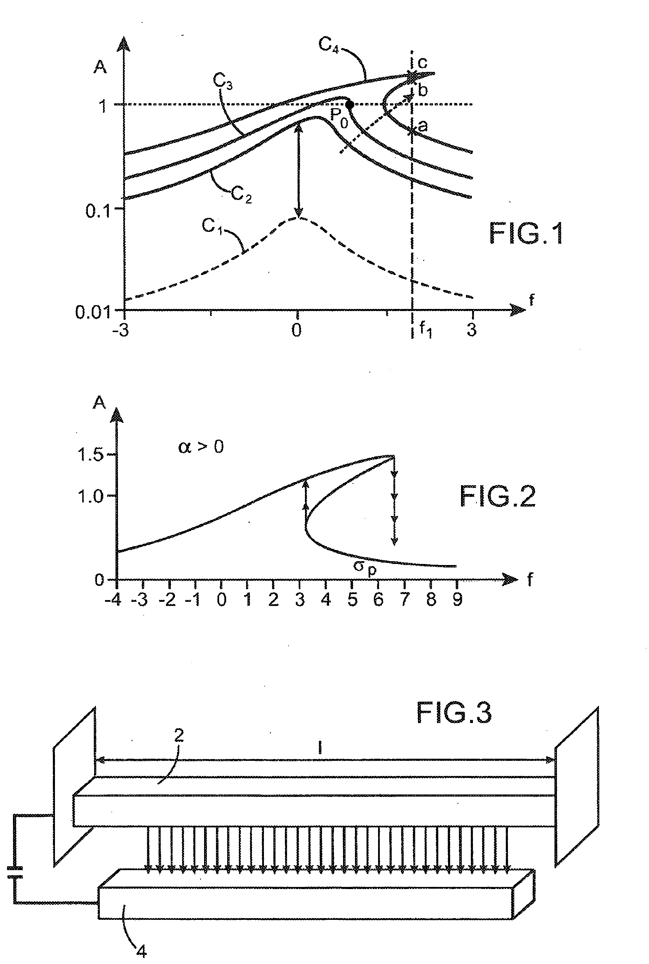

L'homme du métier limite toujours cette amplitude à une valeur inférieure à l'amplitude dite critique, appelée $A_c$, au-delà de laquelle le régime de vibration devient non-linéaire. L'apparition de ce régime non linéaire est illustrée en figure 1. Sur cette figure, sont représentées des courbes $C_n$ d'évolution de la réponse du résonateur en fonction de la fréquence, ou de l'écart de celle-ci par rapport à la fréquence de résonance. On voit que certaines de ces courbes, ici les courbes $C_1$, $C_2$ traduisent un régime linéaire. Au contraire, lorsque l'amplitude augmente, des phénomènes non linéaires apparaissent, ce qui est le cas pour les courbes $C_3$, $C_4$ de la figure 1. Cette non linéarité se traduit, pour certaines fréquences telles que la fréquence f1, par plusieurs amplitudes possibles : par exemple la parallèle à l'axe des ordonnées qui passe par la fréquence f1, coupe la courbe $C_4$ en plusieurs points a, b, c. Cet effet apparaît encore plus clairement sur la figure 2.

Autrement dit, dans ce régime non linéaire, le résonateur n'est plus stable. Dans une certaine zone de ce régime, 3 amplitudes sont possibles pour une fréquence $f_1$ donnée. Le résonateur peut donc « sauter » brutalement d'une amplitude à l'autre quand il est actionné en boucle ouverte à une certaine fréquence. L'amplitude prise par le résonateur dépend en outre des conditions initiales et des perturbations extérieures. Le résonateur devient alors difficilement contrôlable.

Par conséquent, lorsqu'on balaye la gamme de fréquence de manière montante ou descendante, on peut observer des sauts brutaux d'amplitude. En outre le chemin suivi est différent dans un sens ou dans l'autre : on observe une hystérésis, particulièrement visible sur le schéma de la figure 2, c'est-à-dire que suivant le sens dans lequel la fréquence varie, l'évolution de l'amplitude n'est pas la même.

L'apparition d'un régime non linéaire est en outre liée à une dégradation du bruit : en effet du bruit (basse ou haute fréquence) est mélangé par la composante non-linéaire du résonateur, et ramène du bruit à la fréquence d'intérêt, comme cela a été montré par V.Kaajakari et al dans l'article paru dans 20 IEEE Trans. Ultrason. Ferroelectr. Freq. Control, 52, 2322-2331 (2005). Ainsi on augmente l'amplitude et donc la puissance de la porteuse, mais, simultanément, on dégrade le bruit, ce qui réduit totalement l'intérêt d'accroître l'amplitude.

Par conséquent, non seulement le système n'est pas stable en boucle ouverte, mais, en outre, le rapport signal sur bruit se trouve dégradé.

Par opposition à un résonateur du second ordre linéaire, la vibration de tout résonateur mécanique non-linéaire vibrant sur un mode privilégié peut être modélisée par une équation de Duffing, c'est-à-dire comportant un terme non-linéaire du 3e ordre :

$$m_{eff}\ddot{x} + c_{eff}\dot{x} + k_{eff}x + \alpha_{meca}x^3 = F_{act}.$$

où x est l'amplitude de vibration d'un point choisi du résonateur, $F_{act}$ est la force d'actionnement imposée au résonateur et $\alpha_{méca}$ est le coefficient de non-linéarité mécanique du résonateur. Ce coefficient est positif, on dit alors que la non-linéarité est de type durcissante, puisque, comme on le voit clairement sur la figure 2, le pic de résonance s'incline vers les fréquences hautes.

Une technique pour remédier à ce problème à été décrite par L. C. Shao et al., J. Micromech. Microeng. 18 065014-9 (2008) et par M. Agarwal et al., presenté à IEEE International Electron Devices Meeting, Washington, DC,

EP 2 365 282 B1

IEEE (2005). Cette technique permet d'augmenter l'amplitude de vibration au-dessus de l'amplitude critique sans dégrader le bruit. Elle consiste à annuler le coefficient $\alpha_{méca}$ en ajoutant une non-linéarité adoucissante, c'est-à-dire avec un coefficient négatif. Ceci peut être apporté par un actionnement électrostatique.

On prend comme exemple de résonateur le cas d'une capacité plane, souvent utilisée en MEMS, dont la structure peut être symbolisée par une poutre 2, actionnée grâce à une électrode 4, comme illustré en figure 3. L'effort électrostatique s'écrit

$$F_{act} = \frac{1}{2}\varepsilon_0 S \frac{V^2}{(g-x)^2}$$

où S est la surface en regard, g le gap (c'est-à-dire la distance entre les faces en regard de la poutre et de l'électrode), V la différence de potentiel entre électrode et résonateur.

Il est d'usage de traiter cette équation en réalisant un développement limité de l'effort $F_{act}$, et l'équation du mouvement devient :

$$m_{eff}\ddot{x} + c_{eff}\dot{x} + (k_{eff} + \alpha_{elec})x + \alpha_{elec\,2}x^2 + (\alpha_{meca} + \alpha_{elec\,3})x^3 + \sum \alpha_{eleci}x^i = \lambda V^2$$

où les coefficients $\alpha_{eleci}$ d'ordre impair sont négatifs.

Il faut également noter que les termes d'ordre pair n'ont pas d'effet à la résonance (la linéarisation d'un terme quadratique ne génère que des termes multiples de la fréquence de résonance, et aucun terme à la fréquence de résonance), ils ne sont donc pas un problème.

Il est possible d'annuler en particulier ($\alpha_{meca} + \alpha_{elec3}$) pour annuler l'hystérésis. C'est ce qui est montré dans les articles de Shao et al. et de Agarwal et al., déjà cités ci-dessus, mais également dans l'article de Kozinski Et al. Appl. Phys. Lett 88 253101 (2006).

Cependant, cette annulation des non-linéarités est délicate, puisqu'il faut annuler assez précisément la somme des termes d'ordre 3. Elle n'est donc valable que dans un domaine de fonctionnement limité, et surtout elle n'est valable que quand les termes supérieurs (c'est-à-dire les termes en $x^1$, pour i>3) sont négligeables.

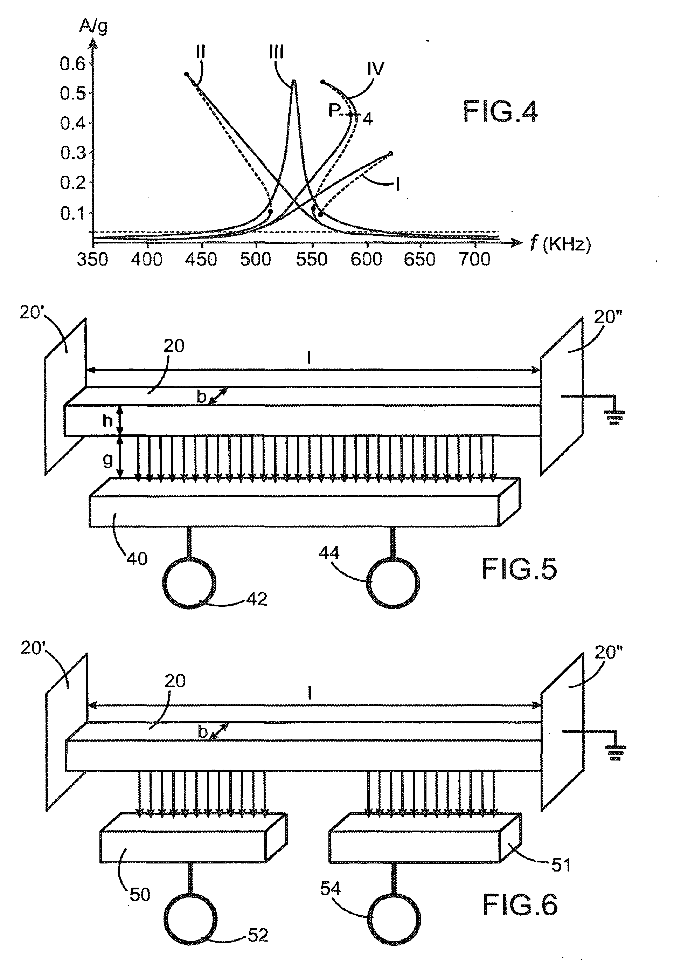

D'autre part, elle amène la plupart du temps à utiliser des tensions très hautes et inutilisables. Ceci explique que cette technique est en pratique très peu utilisée. C'est d'autant plus vrai dans un NEMS pour lequel les dimensions, en particulier le gap, sont très faibles, et dont la zone d'utilisation linéaire est très limitée. Ainsi l'influence des termes supérieurs à 3 devient vite très grande aux dimensions usuelles des NEMS, provoquant l'apparition d'un comportement mixte, durcissant puis adoucissant, hautement instable. Le problème est le même dans le cas des MEMS. Ce comportement est illustré en figure 4, où on a représenté A/g (où A est l'amplitude de vibration mécanique) en fonction de la fréquence et où :

- la courbe I représente le cas non linéaire, décrit ci-dessus, sans actionnement électrostatique, avec un coefficient $\alpha_{méca}$ prépondérant, et avec $V_{dc}$ = 5 V et g = 750 nm,
- la courbe II représente un autre cas de comportement non linéaire, avec un coefficient $\alpha_{élec3}$ prépondérant, et avec $V_{dc}$ = 5 V et g = 400 nm,
- la courbe III représente un cas de comportement linéaire, avec un coefficient $\alpha_{méca} + \alpha_{élec3}$ proche de zéro, et avec $V_{dc}$ = 6 V et g = 500 nm (et une amplitude critique mécanique de 15 nm),
- la courbe IV représente un cas de comportement non linéaire, avec des termes d'ordre supérieurs à 3 non négligeables et avec $V_{dc}$ = 8 V et g = 750 nm.

Sur cette figure le point P représente le point à partir duquel les termes d'ordre 5 ont une influence notable. Il a ici une amplitude de 450 nm.

Sur cette figure encore, les branches stables sont représentées en traits continus, les branches instables en traits interrompus.

Ce comportement rend cette technique d'annulation de $\alpha_{méca} + \alpha_{élec3}$ délicate puisqu'instable, comme cela a été montré par N. Kacem et al., Nanotechnology, 20, 275501 (2009) et par N. Kacem et S. Hentz, dans Appl. Phys.

3

Lett., 95, 183104 (2009).

Il se pose donc le problème de trouver un nouveau procédé et un nouveau dispositif, de type résonateur, permettant de réaliser une suppression de l'effet d'hystérésis (tel que celui illustré ci-dessus en figure 2), de manière stable, tout en permettant l'obtention d'amplitudes de vibration suffisamment élevées pour permettre une réduction efficace du rapport signal sur bruit du résonateur.

## EXPOSÉ DE L'INVENTION

L'invention concerne d'abord un résonateur électromécanique comportant au moins un élément déformable, des moyens d'actionnement de cet élément déformable pour lui appliquer, simultanément, au moins une première force d'actionnement à une première fréquence, et une deuxième force d'actionnement à au moins une deuxième fréquence.

La première et la deuxième fréquences créent au moins deux résonances simultanées à une fréquence de résonance égale à la fréquence d'une des forces d'actionnement.

L'amplitude maximum de déformation de l'élément déformable est supérieure à l'amplitude critique mécanique du résonateur.

Les moyens d'actionnement peuvent être de type électrostatique, et comporter une électrode ou plusieurs électrodes, qui peuvent être disposées parallèlement à au moins une face de l'élément mobile du résonateur.

Un dispositif selon l'invention peut comporter des moyens pour appliquer une première tension alternative, pour créer la première force d'actionnement, et au moins une deuxième tension alternative pour créer le deuxième force d'actionnement.

Un tel dispositif peut comporter en tant qu'élément déformable une poutre, encastrée à une ou deux de ses extrémités (cette poutre pouvant être notamment un nanofil ou un nanotube), ou une membrane, ou une plaque ou un substrat à vibration en volume. L'élément déformable peut être réalisé au moins en partie en matériau semi-conducteur, par exemple en silicium.

L'invention concerne également un procédé pour actionner un résonateur électromécanique ou mécanique comportant au moins un élément déformable, dans lequel on applique à l'élément déformable simultanément au moins une première force d'actionnement à une première fréquence, et au moins une deuxième force d'actionnement à au moins une deuxième fréquence.

La première et la deuxième fréquences créent au moins deux résonances simultanées à une fréquence de résonance égale à la fréquence d'une des forces d'actionnement.

Le mouvement de l'élément déformable est d'amplitude maximum supérieure à l'amplitude critique mécanique du résonateur.

La présente invention propose donc un dispositif et un procédé pour une annulation au moins partielle de l'hystérésis, par mise en oeuvre de résonances simultanées, afin de repousser l'influence des termes d'ordre supérieurs à 5 et stabiliser l'annulation des non-linéarités. On peut alors actionner le résonateur à de très fortes amplitudes de manière linéaire, et profiter pleinement de l'amélioration de ses performances.

Les forces d'actionnement peuvent être appliquées de manière électrostatique, à l'aide d'au moins une électrode.

On peut appliquer par exemple une première tension alternative et au moins une deuxième tension alternative.

Dans un dispositif et un procédé selon l'invention, la première tension alternative ($V_1$) peut être à une fréquence de résonance ($\omega_0$) du dispositif, et au moins une deuxième tension alternative peut être à une fréquence subharmonique ($k\omega_0$, avec k>1) ou à une fréquence super-harmonique ($\omega_0/k$, avec k>1). Dans un mode préféré de réalisation, k = 2.

Dans un autre mode de réalisation, on applique au moins une première tension alternative ($V_1$, $V_2$, $V_{ac}$) et une deuxième tension continue ($V_{dc}$).

De préférence, la somme du coefficient de non-linéarité mécanique et du coefficient de non-linéarité électrique d'ordre 3 est nulle ou proche de zéro (la contribution des termes d'ordre 3 est négligeable par rapport aux termes linéaires, par exemple inférieure à 10% des termes linéaires).

L'utilisation, pour actionner l'élément déformable, de au moins 2 résonances simultanées conformément à l'invention, permet de fonctionner en régime linéaire dans une zone de fonctionnement qui serait non linéaire sans cette résonance simultanée. Le fonctionnement de l'élément déformable dans une zone rendue ainsi linéaire permet d'utiliser des amplitudes de déformations supérieures à l'état de l'art et ainsi d'augmenter le rapport signal/bruit.

## BRÈVE DESCRIPTION DES DESSINS

- Les figures 1, 2 et 4 illustrent des comportements connus de résonateurs, la figure 3 étant une structure connue de résonateur,

EP 2 365 282 B1

- les figures 5 à 11 sont des modes de réalisation de l'invention.
- la figure 12 représente des résultats obtenus avec un dispositif selon l'invention.
- la figure 13 représente un nanofil,
- les figures 14A - 14G sont des étapes de réalisation d'un résonateur auquel peut être appliqué l'invention.

## EXPOSE DETAILLE DE MODE DE REALISATION DE L'INTENTION

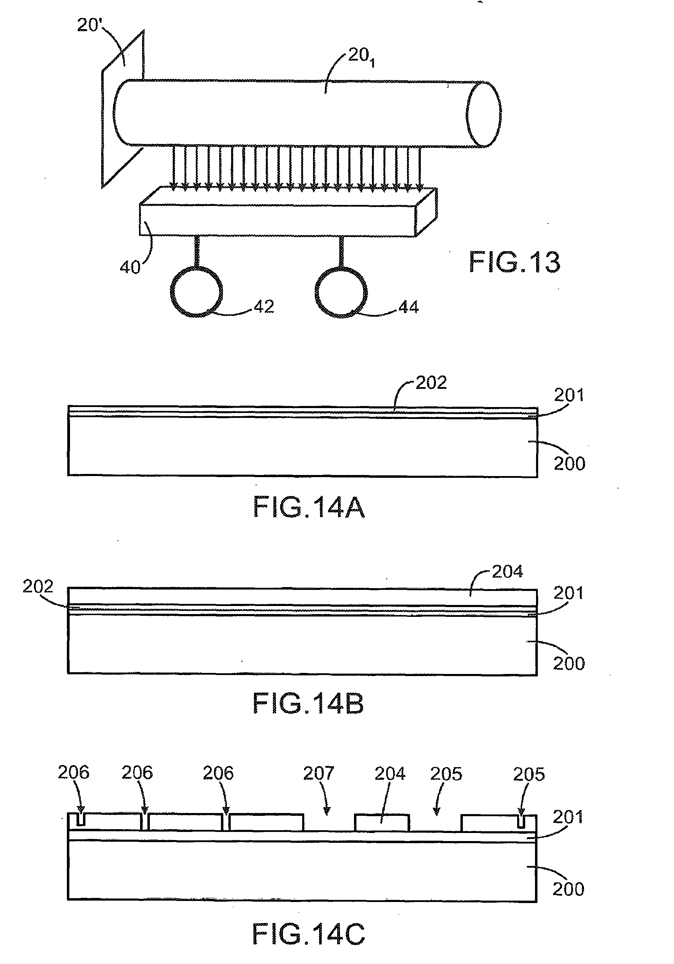

Selon un premier exemple de l'invention on met en oeuvre un résonateur, par exemple une poutre encastrée 20, non-linéaire, auquel sont appliquées simultanément une résonance super- ou subharmonique et une résonance primaire. Précisons qu'une poutre peut être à section carrée ou rectangulaire (comme sur les figures), mais en variante de section quelconque, notamment circulaire, comme pour un nanofil $20_1$ (comme sur la figure 13) ou un nanotube.

Soit un résonateur non-linéaire d'ordre n auquel on applique une force d'amplitude F et de fréquence propre

$$\omega \;=\; \omega_0 = \sqrt{\frac{k_{eff}}{m_{eff}}}$$ . L'équation du mouvement de ce résonateur est :

$$m_{eff}\ddot{x} + c_{eff}\dot{x} + k_{eff}x + \alpha_n x^n = F\cos\omega t$$

Si le résonateur était purement linéaire (soit $\alpha_n=0$) on n'observerait qu'une résonance dite primaire lorsque $\omega=\omega_0$ . La résonance primaire est celle à laquelle il y a résonance si le résonateur est purement linéaire.

Du fait des termes non-linéaires on observe des résonances du résonateur sur son mode propre à $\omega_0$ lorsque $\omega=\omega_0/n$ (résonance superharmonique) et lorsque $\omega=n\omega_0$ (résonance subharmonique).

Soit maintenant un résonateur à double excitation, c'est-à-dire que la force d'excitation comporte une composante d'amplitude $F_1$ (et de pulsation $\omega_1$) et composante d'amplitude $F_2$ (et de pulsation $\omega_2$) :

$$m_{eff}\ddot{x} + c_{eff}\dot{x} + k_{eff}x + \alpha_n x^n = F_1\cos\omega_1 t + F_2\cos\omega_2 t$$

On peut donc ainsi exciter simultanément la résonance primaire avec $\omega_1=\omega_0$ et une résonance super-harmonique ou subharmonique avec $\omega_2 = \omega_0/n$ ou $\omega_2 = n\omega_0$ (n>1).

On a alors des résonances simultanées.

Selon l'invention on met en oeuvre des moyens pour réaliser cette double excitation et la régler afin d'exciter la résonance primaire, à la fréquence $\omega_1=\omega_0$, jusqu'à des amplitudes qui amènent le résonateur dans un régime non-linéaire. Autrement dit l'amplitude du mouvement est supérieure à l'amplitude critique, à partir de laquelle on peut avoir plusieurs amplitudes pour une fréquence donnée (sur la figure 1, il s'agit de l'amplitude $A_c$ du point $P_0$). L'amplitude critique est la limite entre un régime de vibration linéaire et celui d'un régime non linéaire.

En outre, le dispositif est amené dans des conditions où les termes d'ordre 3 s'annulent ou deviennent négligeables devant les termes d'ordre 1 (ou la valeur des termes d'ordre 3 est inférieure à 10%, ou même à 5%, de celle des termes d'ordre 1). Pour ce faire on peut jouer sur les paramètres d'amplitude de la tension, de gap g et de surface S, mais la résonance simultanée contribue aussi à la réduction des termes d'ordre 3.

En terme de représentation graphique, telle que celle de la figure 4, cela signifie qu'on repousse la valeur limite (la position du point P) de sorte qu'on peut mettre en oeuvre des amplitudes plus importantes que celles mises en oeuvre lors d'un simple comportement linéaire.

L'invention permet de stabiliser le comportement du résonateur grâce à la superposition de la résonance subharmonique ou superharmonique avec la résonance primaire, pour ainsi annuler l'hystérésis jusqu'à des amplitudes bien plus grande que sans résonance simultanée.

On réalise ainsi du « pompage énergétique », en transférant de l'énergie d'une première résonance à une autre (subharmonique ou superharmonique) afin de stabiliser la première.

Un exemple de réalisation de l'invention est illustré en figure 5.

Sur cette figure, la référence 20 désigne une poutre, dans cet exemple encastrée à ses deux extrémités 20', 20", cette poutre ayant une longueur l (par exemple comprise entre 500 nm et 500 $\mu$m, ou par exemple encore entre 500 nm et 100 $\mu$m, ou par exemple encore entre 500 nm et 10 $\mu$m) une épaisseur h (par exemple comprise entre 10 nm et 10 $\mu$m, ou par exemple encore entre 10 nm et 1 $\mu$m, ou par exemple encore entre 10 nm et 500 nm) et une largeur b (par exemple comprise entre 10 nm et 10 $\mu$m, ou par exemple encore entre 10 nm et 1 $\mu$m, ou par exemple encore entre 10 nm et 500 nm).

La référence 40 désigne une électrode, disposée de manière sensiblement parallèle à la poutre 20, à une distance, ou « gap », g de celle-ci (par exemple compris entre 10 nm et 10 $\mu$m, ou par exemple encore entre 10 nm et 1 $\mu$m, ou par exemple encore entre 10 nm et 500 nm).

Cette électrode 40 est munie de moyens générateurs de tension 42, 44, qui vont permettre de lui appliquer, respectivement :

- une tension alternative d'amplitude $V_1$ et de pulsation $\omega_1=\omega_0$ ($\omega_0$ est la fréquence primaire telle que définie ci-dessus), superposée à une tension continue $V_{dc1}$, ou de pulsation $\omega_1=\omega_0/2$ si $V_{dc1} = 0$;
- une tension alternative d'amplitude $V_2$ et de pulsation $\omega_2=\omega_0/2$ (en variante, on peut choisir $\omega_2=2\omega_0$), superposée à une tension continue $V_{dc2}$ ; ou de pulsation $\omega_2=\omega_0/4$ si $V_{dc2} = 0$;

Selon cet exemple, on superpose donc deux harmoniques sur une même électrode 40.

La longueur de l'électrode et le gap sont dimensionnés, avec $V_1$ et $V_2$, afin d'obtenir l'influence des 2 résonances (primaire et sub-harmonique ou super-harmonique) simultanément et d'amener le résonateur à des amplitudes de vibration supérieures à l'amplitude critique mécanique.

Un autre exemple de réalisation est illustré en figure 6. Selon cet exemple, les harmoniques sont réparties sur des électrodes différentes 50, 51, respectivement situées à une distance $g_0$ et une distance $g_1$ de la poutre 20.

Autrement dit:

- l'électrode 50 est munie d'un générateur de tension 52 qui va permettre de lui appliquer une tension alternative d'amplitude $V_1$ et de pulsation $\omega_1= \omega_0$, superposée à une tension continue $V_{dc1}$ ($\omega_0$ est la fréquence primaire telle que définie ci-dessus) ; ou de pulsation $\omega_1=\omega_0/2$ si $V_{dc1} = 0$;
- l'électrode 51 est munie d'un générateur de tension 54 qui va permettre de lui appliquer une tension alternative d'amplitude $V_2$ et de pulsation $\omega_1= \omega_0/2$ (en variante, on peut choisir $\omega_2=2\omega_0$), superposée à une tension continue $V_{dc2}$; ou de pulsation $\omega_2=\omega_0/4$ si $V_{dc2}=0$.

La longueur de l'électrodes 50 peut être différente de celle de l'électrodes 51. Le gap $g_0$ peut être différent du gap $g_1$. Ces paramètres sont dimensionnés, avec $V_1$ et $V_2$, afin d'obtenir l'influence des 2 résonances (primaire et sub-harmonique ou super-harmonique) simultanément et d'amener le résonateur à des amplitudes de vibration supérieures à l'amplitude critique mécanique.

Dans les deux exemples qui viennent d'être décrits, on réalise l'obtention de 2 forces électrostatiques à 2 fréquences différentes avec un ou deux signaux électriques alternatifs.

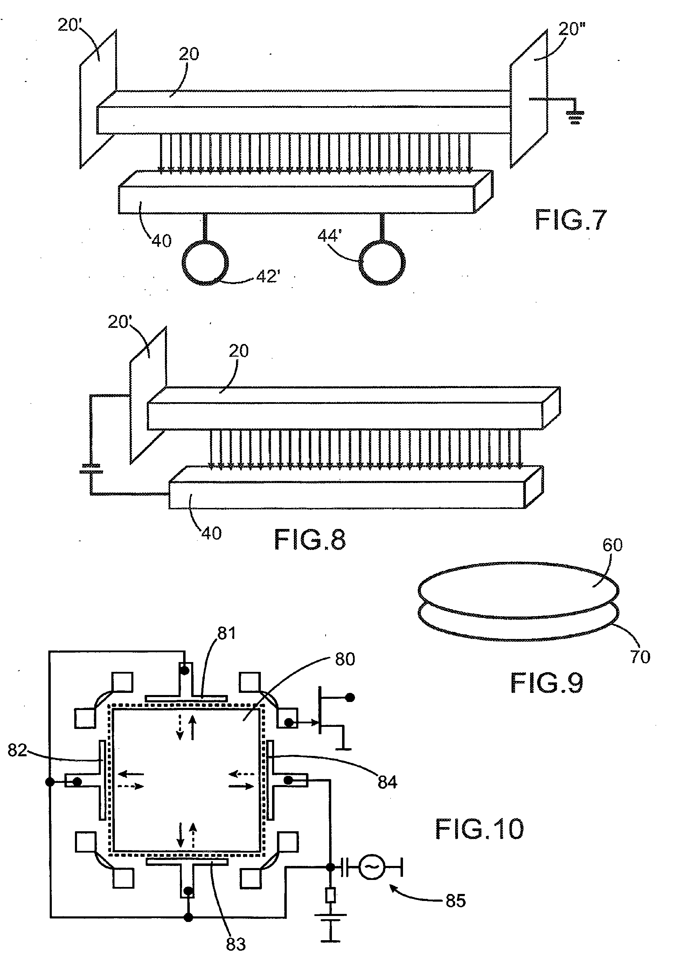

Un autre exemple de réalisation est illustré en figure 7.

Cette structure comporte des éléments identiques ou similaires (poutre 20, électrode 40) à ceux qui ont déjà été décrits ci-dessus en liaison avec la figure 5.

L'électrode 40 est cette fois munie de moyens générateurs de tension 42', 44' qui vont permettre de lui appliquer simultanément, respectivement :

- une tension alternative d'amplitude $V_1$ et de pulsation $\omega_1=\omega_0/2$ ou $\omega_0$;
- une tension continue d'amplitude $V_{dc}$.

On réalise alors l'obtention de 2 forces électrostatiques à 2 fréquences différentes avec un seul signal électrique alternatif et un signal électrique continu.

Dans ce cas, on utilise un actionnement électrostatique avec superposition d'une tension continue et d'une tension alternative.

On a ainsi, si on se limite à l'ordre 3 :

$$m_{eff}\ddot{x} + c_{eff}\dot{x} + (k_{eff} + \alpha_{elec})x + \alpha_{elec2}x^2 + (\alpha_{meca} + \alpha_{elec3})x^3 =$$
$$\lambda(V_{ac}\cos\omega t + V_{dc})^2 = \lambda_1 V_{ac} V_{dc} \cos\omega t + \lambda_2 V_{ac}^{2} \cos 2\omega t$$

Ainsi avec un seul signal électrique alternatif de pulsation $\omega=\omega_0/2$ ou $\omega_0$, on obtient un effort électrostatique de pulsation $\omega_0$ responsable de la résonance primaire, et un effort électrostatique de pulsation $\omega_0/2$ responsable de la

résonance superharmonique à $\omega_0$ (de pulsation $2\omega_0$ responsable de la résonance subharmonique à $\omega_0$), grâce au terme non linéaire d'ordre 2 dans l'équation du mouvement.

Ce dispositif peut être réalisé à partir d'un dispositif de caractérisation connu, par exemple avec un lock-in en mode 2f (on mesure l'amplitude de l'harmonique de sortie à 2 fois la fréquence d'actionnement). On remarquera que, dans les dispositifs connus, on utilise des valeurs des tensions alternative $V_{ac}$ et continue $V_{dc}$ telles que $V_{ac} \ll V_{dc}$, afin de pouvoir négliger un harmonique par rapport à l'autre. Evidemment, classiquement, le domaine non linéaire est évité, donc l'influence du $2^e$ harmonique est inexistante. Ici, au contraire, on utilise une tension continue et une tension alternative comparables ($V_{dc}$ est par exemple compris entre $V_{ac}$ et $10V_{ac}$) ce qui permet d'amener le résonateur dans le domaine non linéaire, afin de bénéficier des résonances simultanées.

Pour chacun des exemples de réalisation décrits, on peut utiliser, ou pas, une tension continue $V_{dc}$ superposée aux autres tensions. La caractérisation électrique peut être effectuée par exemple avec un lock-in du commerce en mode 1f ou 2f selon la résonance à utiliser.

Chacun des dispositifs décrits peut comporter en outre des moyens de détection, par exemple de type électrostatique ou piezorésistif, ou autre.

La structure mécanique d'un dispositif selon l'invention peut être :

- une poutre encastrée à deux extrémités 20', 20" (cas des figures 5-7) ou à une seule extrémité 20' (cas de la figure 8),
- ou une poutre avec d'autres conditions aux limites, par exemple en appui simple sur un côté et encastrée de l'autre côté ou en appui simple sur deux côtés;
- la poutre pouvant être un nanofil $20_1$ (comme sur la figure 13) ou un nanotube, encastré à une extrémité 20' (cas de la figure 13) ou en appui simple sur un côté ou deux côtés;
- ou une membrane ou une plaque 60, plane, circulaire ou carrée ou rectangulaire ou de toute autre forme, en flexion : c'est le cas de la figure 9 où cette plaque 60 est disposée en face d'une électrode 70, par exemple de même forme que celle de la membrane ou de la plaque 60 et à laquelle des résonances simultanées peuvent être appliquées de la manière déjà expliquée ci-dessus pour une poutre ; elle peut être encastrée sur tout ou partie de sa périphérie,
- ou une structure en mode de volume : c'est le cas de la figure 10. Ce type de dispositif est expliqué de manière plus détaillée dans V.Kaajari et al., »Square extensional mode single-crystal micromechanical RF resonator », in Proc. Transducers 04, Int.Conf. Solid State Sens. Actuators, 2004, p ;951-954 et dans »Square extensional mode single-crystal micromechanical resonator for low phase noise oscillator applications», IEEE Electron. Device Lett., vol.25, 4, p.173-175, 2004. Les mouvements d'une plaque ou d'un substrat 80 sont alors dans son propre plan, suivant les flèches indiquées en figure 10 (d'autres modes peuvent être mis en oeuvre, par exemple le mode de Lamé); des électrodes 81, 82, 83, 84, reliées à des moyens 85 pour fournir les tensions voulues, permettent d'actionner ces mouvements, auxquels, conformément à l'invention, des résonances simultanées peuvent être appliquées de la manière déjà expliquée ci-dessus (à chaque électrode on applique les deux tensions ou bien on applique une tension alternative à deux électrodes opposées et une tension continue aux deux autres électrodes opposées, ou bien on applique une tension alternative aux 4 électrodes et une tension continue à la plaque 80).

Comme indiqué dans les exemples ci-dessus, avantageusement, on utilise n=2 dans les termes non linéaires de l'équation de mouvement, c'est-à-dire des harmoniques dont une fréquence est le double de l'autre. Mais d'autres variantes peuvent être mises en oeuvre, avec une fréquence $\omega_0$ et une fréquence $k\omega_0$ ou encore $\omega_0/k$, avec $k>2$.

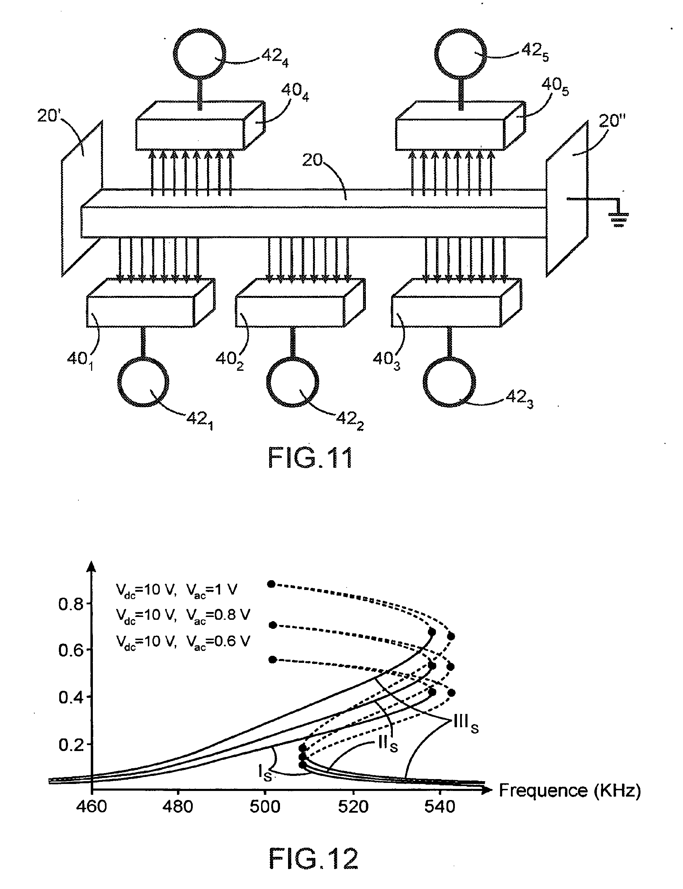

Encore un autre exemple de réalisation est celui du dispositif de la figure 11, avec n applications de tensions, de fréquences $\omega_1, \omega_2, \omega_3, \omega_4, \omega_5$. On pourra prendre $\omega_1 = \omega_0$ (fréquence primaire).

Selon cet exemple, les harmoniques sont réparties sur des électrodes différentes $40_i$, ($i = 1,...5$) respectivement situées à une distance $g_i$ de la poutre 20.

Autrement dit chacune des électrodes $40_i$ est munie d'un générateur de tension $42_i$ qui va permettre de lui appliquer une tension alternative d'amplitude $V_i$ et de pulsation $\omega_1 = \omega_0$, ou $\omega_i = i\omega_0$ ou $\omega_0/i$ qui peut être superposée à une tension continue $V_{dci}$.

Les longueurs $l_i$ des électrodes $40_i$ peuvent être différentes entre elles. Les gap $g_i$ des électrodes $40_i$ peuvent être différents entre eux. Ces paramètres géométriques sont dimensionnés, avec $V_i$, afin d'obtenir l'influence des diverses résonances (primaire et sub-harmonique ou super-harmonique) simultanément.

Plus généralement, soit un système à n excitations :

$$m_{eff}\ddot{x} + c_{eff}\dot{x} + k_{eff}x + \sum_{i=2}^{n} \alpha_i x^i = \sum_{i=2}^{n} F_i \cos\omega_i t$$

On peut alors exciter simultanément la résonance primaire avec $\omega_1=\omega_0$ et plusieurs résonances sub ou super-rharmonique avec $\omega_i=\omega_0/i$ ou $\omega_i=i\omega_0$ (i>1).

L'invention permet donc la réalisation d'une multi excitation, réglée afin d'exciter la résonance primaire, jusqu'à des amplitudes qui amènent le résonateur dans un régime non-linéaire et dans des conditions où les termes d'ordre 3 peuvent s'annuler comme déjà expliqué ci-dessus.

On stabilise le comportement du résonateur grâce à plusieurs résonances sub ou superharmoniques, pour ainsi rendre possible l'utilisation du dispositif dans un domaine d'amplitude exempt d'hystérésis.

On réalise ainsi du «pompage énergétique» en cascade, en transférant de l'énergie d'une première résonance à une deuxième résonance afin de stabiliser la première.

Ce type d'excitation est très pratique pour les nanorésonateurs.

En effet, plus on réduit les tailles des dispositifs, plus les nonlinéarités d'ordre au moins égal à 5 limitent le domaine de la suppression d'hystérésis près de l'amplitude critique. A certaines tailles (notamment celles d'un nanofil, ou d'un nanotube ; la poutre 20 peut être un nanofil ou un nanotube), une seule résonance n'est pas suffisante pour l'effet voulu, c'est-à-dire la présence d'un pic linéaire à très large amplitude d'oscillation. Plusieurs électrodes peuvent ainsi être utilisées pour une multi-excitation en résonances simultanées (une excitation à la fréquence primaire $\omega_0$ et n (n>0) superharmoniques $\omega_k(n\geq k>0)$).

Quel que soit le mode de réalisation adopté, l'annulation de l'hystérésis grâce aux résonances simultanées peut être obtenue de diverses manières. On décrit ci-dessous une démarche expérimentale pour dimensionner un résonateur destiné à fonctionner selon l'invention.

Il est en effet possible, expérimentalement, de définir les dimensions de la structure pour approcher les performances globales recherchées, et en particulier la fréquence de travail souhaitée.

Le gap g peut être fixé pour permettre l'amplitude de vibration souhaitée, c'est-à-dire la plus grande possible pour l'application envisagée. Comme expliqué ci-dessus ce gap permet l'annulation des termes d'ordre 3 et l'influence de la résonance sub- ou superharmonique; une règle approximative consiste à utiliser un gap g de l'ordre de grandeur de la dimension vibrante de la structure (cette dimension vibrante est la largeur h de la poutre de la figure 5 mesurée sensiblement parallèlement à sa direction de vibration) ; par exemple le gap est compris entre 10 nm et 100 nm.

On cherche ensuite à s'approcher le plus possible du domaine de fonctionnement où les travaux antérieurs cherchent à annuler les termes d'ordre 3. C'est-à-dire qu'on cherche à atteindre l'amplitude de vibration mécanique dite critique $A_c$, soit uniquement avec une tension alternative, soit en superposant une tension continue à cette tension alternative, mais en gardant $V_a<<V_{dc}$, comme cela est toujours pratiqué de manière connue. On cherche alors à observer une légère influence de la variation de ces tensions, non seulement sur l'amplitude du pic, mais aussi sur sa forme.

On peut alors augmenter la valeur de tension alternative, jusqu'à observer l'influence des termes d'ordre supérieur, c'est-à-dire le comportement mixte ou des instabilités brutales.

L'étape suivante consiste à exploiter l'effet des résonances simultanées :

- Dans le cas où on utilise 2 tensions alternatives : $V_1$ entraîne la résonance primaire, et $V_2$ la résonance sub ou super harmonique. On peut alors augmenter progressivement l'amplitude du 2e harmonique, lorsqu'on utilise 2 signaux électriques, afin de stabiliser le pic, puis, de manière itérative, augmenter successivement $V_1$ et $V_2$ de proche en proche (afin d'accroître l'amplitude tout en conservant un comportement linéaire).

- Lorsqu'un seul signal électrique est utilisé (avec une composante alternative et une composante continue), la résonance primaire est pilotée par $V_{ac}^2$, et la résonance sub ou superharmonique par $V_{dc}V_{ac}$. On cherche alors à augmenter de manière itérative les tensions $V_{dc}$ et $V_{ac}$ pour stabiliser le comportement tout en augmentant l'amplitude d'actionnement.

On peut avoir recours à une modélisation pour prévoir approximativement les valeurs des tensions à utiliser. Des modèles semi-analytiques peuvent être utilisés comme expliqué dans l'article de Kacem et al., J. Micromech. Microeng. 20, 2010, pour prévoir les amplitudes à atteindre.

La tension $V_{dc}$ optimale peut être estimée analytiquement pour une configuration donnée en équilibrant les deux non-linéarités d'ordre 3 (la composante mécanique et la composante électrostatique). Ceci correspond à une égalité entre les deux amplitudes critiques (mécanique et électrostatique).

Par exemple, dans le cas d'un résonateur de type poutre encastré sur une seule extrémité 20' et libre à l'autre extrémité 20" (cas de la figure 8), les amplitudes critiques mécanique et électrostatique sont données respectivement par les expressions suivantes, tirées de l'article de Kacem et al. précité, où l est la longueur de la poutre, Q le facteur de qualité de la poutre, et $A_{cm}$ l'amplitude critique:

$$A_{cm} = 6.3 \frac{l}{\sqrt{Q}}$$

$$A_{ce} = 2*10^9 g^{\frac{5}{2}} \frac{h}{l V_{dc} \sqrt{Q}} \left( \frac{7.5*10^7 h^2}{l^4} - \frac{3.8*10^{-15} V_{dc}^2}{g^3 h} \right)^{\frac{1}{4}}$$

La tension $V_{dc}$ optimale est donc :

$$V_{dcOP} = \sqrt{\frac{1}{2} \sqrt{\frac{1.65*10^{39} g^{14} h^6}{l^{16}} + \frac{3.2*10^{42} g^{10} h^6}{l^{12}} - \frac{8.1*10^{19} gh^3}{l^8}}}$$

Une fois la tension DC fixée, on applique des tensions AC, par exemple 2 à 5 fois ou 1 à 10 fois plus faibles que la tension DC (comme déjà expliqué ci-dessus) pour assurer un effet de pompage énergétique dû à la résonance super harmonique.

De préférence on se ramène à un système réglable sur lequel on peut superposer un nombre de superharmoniques ou de subharmoniques qui dépend du niveau d'instabilité et des ordres des non linéarités. Ceci permet un contrôle direct (actif) de la forme du pic sous résonances simultanées. Plus les instabilités sont hautes, plus on corrige en ajoutant des superharmoniques ou des subharmoniques jusqu'à obtention de l'effet voulu.

D'autre part, on peut avoir recours à un calcul par éléments finis. La démarche à utiliser reste la même que la démarche expérimentale décrite ci dessus.

Dans un dispositif et un procédé selon l'invention, l'effet de la résonance sub- ou superharmonique est de repousser l'influence des termes d'ordre supérieurs à 3.

Comme indiqué précédemment, ceux-ci se manifestent par un comportement dit mixte, montrant de fortes instabilités : l'influence de ces termes est visualisée par l'existence et l'amplitude du point P, sur la courbe IV de la figure 4.

On peut montrer que, lorsqu'on n'utilise que la résonance primaire (sans super- ou sub harmonique), l'amplitude à ce point P n'est fixée que par la géométrie du dispositif (dimensions du résonateur, et gap). Ainsi le domaine de vibration du résonateur est limité par l'apparition des termes d'ordre supérieur, c'est-à-dire par l'amplitude de ce point P, qui est elle-même fixée par la géométrie, sans possibilité de la modifier, de quelque manière y compris par les tensions d'utilisation du dispositif. Ce domaine est donc très limité.

En revanche, l'utilisation de résonances simultanées conformément à l'invention permet de modifier à souhait l'amplitude de ce point P, et donc de repousser l'influence des termes supérieurs, en fonction de la proportion relative de résonance primaire et de résonance sub ou superharmonique.

C'est ce que montre la figure 12, qui représente, pour 3 cas (identifiés par les références $I_s$, $II_s$, $III_s$), l'amplitude mécanique de vibration en fonction de la fréquence, en régime de résonances simultanées, selon l'invention, obtenu ici par superposition d'une tension alternative d'amplitude $V_{ac}$ (0,6 V pour $I_s$, 0,8 V pour $II_s$, 1 V pour $III_s$), et d'une tension continue $V_{dc}$ (10 V pour $I_s$, 10 V pour $II_s$, 10 V pour $III_s$). Les branches stables sont représentées en traits continus, les branches instables en traits interrompus. On voit que le rapport entre $V_{dc}$ et $V_{ac}$ peut même être un peu en dehors de la gamme déjà indiquée ci-dessus. On notera que, sur cette figure, est représenté un comportement mixte, sans suppression des termes d'ordre 3: si, en outre, on se place dans des conditions permettant d'annuler ces termes d'ordre 3, on observe alors un pic tel que celui de la courbe III (figure 4) mais avec une amplitude beaucoup plus importante.

Un dispositif et un procédé selon l'invention permettent d'augmenter la puissance $P_0$ de la porteuse du résonateur, sans augmenter le bruit produit. On peut donc augmenter le rapport signal sur bruit, et donc les performances du dispositif, tout en conservant sa stabilité et en ne dégradant pas son bruit.

Des exemples de dispositif auxquels on peut appliquer l'invention sont décrits dans les publications mentionnées ci-dessus. L'article de N. Kacem et al., Nanotechnology, 20, 275501 (2009), décrit en outre une technique de réalisation d'un résonateur, mettant en ouvre les techniques de la microélectronique, à partir d'un substrat SOI.

L'article de L. C. Shao et al., J. Micromech. Microeng. 18 065014-9 (2008) décrit la réalisation d'un autre dispositif à partir, également, d'un substrat SOI.

Un autre exemple de réalisation d'un résonateur est décrit dans J.Arcamone et al. « Full wafer fabrication Full-wafer fabrication by nanostencil lithography of micro/nanomechanical mass sensors monolithically integrated with CMOS", Nanotechnology, 19 (2008) 305302.

Encore un autre exemple de réalisation d'un résonateur est donné en liaison avec les figures 14A - 14G.

L'élément de départ, en figure 14A, est un substrat de type SOI, comportant une couche 201 d'oxyde d'environ 1 μm d'épaisseur sur un substrat 200 en silicium, cette couche d'oxyde étant recouverte d'une fine couche de silicium 202 de 400 nm d'épaisseur environ.

On fait croître sur ce substrat de départ une couche 204 de silicium par épitaxie, sur une épaisseur d'environ 4 μm. Cette couche est dopée in situ (figure 14B).

Des étapes de photolithographie puis de gravure vont permettre de définir la géométrie d'un MEMS. Les références 205, 206, 207 désignent, sur la figure 14C, des zones gravées de la couche superficielle 204.

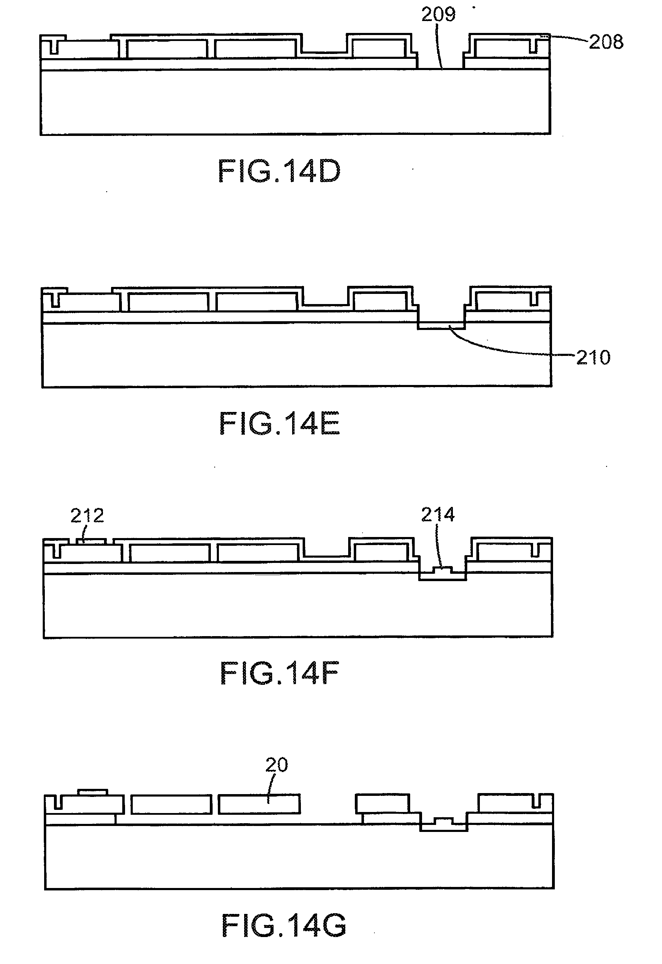

On dépose ensuite (figure 14D) une couche 208 d'oxyde conforme, puis on réalise des étapes de photolithographie et de gravure en vue d'ouvrir des zones 209 de formation de plots de connexion.

Une implantation de bore permet de définir ces plots 210 (figure 14E), qui sont terminés (figure 14F) par un dépôt d'un matériau formant les contacts, par exemple d'AlSi, auquel on peut appliquer des étapes de photolithographie et de gravure afin de bien définir les plots.

Enfin (figure 14G), on dégage le résonateur 20 lui-même, par attaque au HF en phase vapeur de la couche d'oxyde 201.

## Revendications

1. Résonateur électromécanique comportant au moins un élément déformable (20, 60, 80), des moyens (42, 44, 52, 54, 42', 44', $40_1$ - $40_5$, 81 - 84) d'actionnement de cet élément déformable, **caractérisé en ce que** ces moyens d'actionnement sont adaptés pour appliquer à cet élément déformable, simultanément, au moins une première force d'actionnement à une première fréquence, et une deuxième force d'actionnement à au moins une deuxième fréquence, la première et la deuxième forces créant au moins deux résonances simultanées à une fréquence de résonance égale à la fréquence d'une des forces d'actionnement.

2. Résonateur selon la revendication 1, les moyens d'actionnement étant de type électrostatique, et comportant au moins une électrode (40, 50, 51).

3. Résonateur selon la revendication 2, comportant des moyens pour appliquer aux moyens (20, 70) d'actionnement de type électrostatique, au moins une première tension alternative ($V_1$) pour créer la première force d'actionnement et une deuxième tension alternative ($V_2$, $V_3$, $V_4$, $V_n$) pour créer la deuxième force d'actionnement

4. Résonateur selon la revendication 3, la première tension alternative ($V_1$) étant à ladite première fréquence, celle-ci étant choisie égale à la fréquence de résonance ($\omega_c$) du dispositif, et la deuxième tension alternative étant à ladite deuxième fréquence, celle-ci étant choisie égale à une fréquence de résonance subharmonique ($k\omega_0$, avec k>1) du résonateur, ou à une fréquence de résonance superharmonique ($\omega_0$/k, avec k>1).

5. Résonateur selon la revendication 4, dans lequel k = 2.

6. Résonateur selon la revendication 2, comportant des moyens pour appliquer au moins une première tension alternative ($V_1$, $V_2$, $V_{ac}$) et une deuxième tension continue ($V_{dc}$) aux moyens (20, 70) d'actionnement électrostatique.

7. Résonateur selon l'une des revendications précédentes, dans lequel l'élément déformable est une poutre (20), encastrée à une ou deux de ses extrémités (20', 20"), ou une membrane (60), ou une plaque ou un substrat (80) à vibration en volume.

8. Résonateur selon la revendication 7, dans lequel l'élément déformable est un nanofil ou un nanotube.

9. Résonateur selon l'une des revendications précédentes, dans lequel la somme du coefficient de non-linéarité mécanique et du coefficient de non-linéarité électrique d'ordre 3 est nulle ou proche de zéro.

10. Procédé pour actionner un résonateur électromécanique comportant au moins un élément déformable (20, 60, 80), dans lequel on applique à cet élément déformable, simultanément, au moins une première force d'actionnement à une première fréquence, et une deuxième force d'actionnement à au moins une deuxième fréquence, la première et la deuxième fréquences créant au moins deux résonances simultanées à une fréquence de résonance égale à la fréquence d'une des forces d'actionnement.

11. Procédé selon la revendication 10, les forces d'actionnement étant appliquées de manière électrostatique, à l'aide d'au moins une électrode (40, 70, 81 - 84).

12. Procédé selon la revendication 11, dans lequel on applique au moins une première tension alternative ($V_1$) et au moins une deuxième tension alternative ($V_2$, $V_3$, $V_4$, $V_n$) .

13. Procédé selon la revendication 12, la première tension alternative ($V_1$) étant ladite première fréquence, celle-ci étant choisie égale à la fréquence de résonance ($\omega_0$) du résonateur, et au moins une deuxième tension alternative étant ladite deuxième fréquence, choisie égale à une fréquence de résonance subharmonique ($k\omega_0$, avec k>1) ou à une fréquence de résonance superharmonique ($\omega_0$/k, avec k>1) du résonateur, de préférence k = 2.

14. Procédé selon la revendication 11, dans lequel on applique au moins une première tension alternative ($V_1$, $V_2$, $V_{ac}$) et une deuxième tension continue ($V_{dc}$).

15. Procédé selon l'une des revendications 10 à 14, dans lequel la somme du coefficient de non-linéarité mécanique et du coefficient de non-linéarité électrique d'ordre 3 est nulle ou proche de zéro.

**Patentansprüche**

1. Elektromechanischer Resonator, umfassend wenigstens ein verformbares Element (20, 60, 80) sowie Mittel (42, 44, 52, 54, 42', 44', $40_1$-$40_5$, 81-84) zur Betätigung dieses verformbaren Elements, **dadurch gekennzeichnet, dass** diese Betätigungsmittel dazu ausgelegt sind, an dieses verformbare Element gleichzeitig wenigstens eine erste Betätigungskraft mit einer ersten Frequenz und eine zweite Betätigungskraft mit wenigstens einer zweiten Frequenz anzulegen, wobei die erste und die zweite Kraft wenigstens zwei gleichzeitige Resonanzen mit einer Resonanzfrequenz gleich der Frequenz einer der Betätigungskräfte erzeugen.

2. Resonator nach Anspruch 1, wobei die Betätigungsmittel vom elektrostatischen Typ sind und wenigstens eine Elektrode (40, 50, 51) umfassen.

3. Resonator nach Anspruch 2, umfassend Mittel zum Anlegen wenigstens einer ersten Wechselspannung ($V_1$) an die Betätigungsmittel (20, 70) vom elektrostatischen Typ, um die erste Betätigungskraft zu erzeugen, sowie eine zweite Wechselspannung ($V_2$, $V_3$, $V_4$, $V_n$), um die zweite Betätigungskraft zu erzeugen.

4. Resonator nach Anspruch 3, wobei die erste Wechselspannung ($V_1$) bei der ersten Frequenz ist, wobei diese gleich der Resonanzfrequenz ($\omega_c$) der Vorrichtung ist, und wobei die zweite Wechselspannung bei der zweiten Frequenz ist, wobei diese gleich einer subharmonischen Resonanzfrequenz ($k\omega_0$, mit k>1) des Resonators gewählt ist, oder bei einer superharmonischen Resonanzfrequenz ($\omega_0$/k, mit k>1).

5. Resonator nach Anspruch 4, bei dem k = 2 ist.

6. Resonator nach Anspruch 2, umfassend Mittel zum Anlegen wenigstens einer ersten Wechselspannung ($V_1$, $V_2$, $V_{ac}$) und einer zweiten Gleichspannung ($V_{dc}$) an die elektrostatischen Betätigungsmittel (20, 70).

7. Resonator nach einem der vorhergehenden Ansprüche, bei dem das verformbare Element ein Balken (20) ist, der an einem oder beiden seiner Enden (20', 20") eingespannt ist, oder eine Membran (60) oder eine Platte oder ein Substrat (80) mit Volumenschwingung.

8. Resonator nach Anspruch 7, bei dem das verformbare Element ein Nanodraht oder eine Nanoröhre ist.

9. Resonator nach einem der vorhergehenden Ansprüche, bei dem die Summe des mechanischen Nichtlinearitätskoeffizienten und des elektrischen Nichtlinearitätskoeffizienten dritter Ordnung Null oder nahe bei Null ist.

10. Verfahren zur Betätigung eines elektromechanischen Resonators, umfassend wenigstens ein verformbares Element (20, 60, 80), bei dem man an dieses verformbare Element gleichzeitig wenigstens eine erste Betätigungskraft mit einer ersten Frequenz und eine zweite Betätigungskraft mit wenigstens einer zweiten Frequenz anlegt, wobei die erste und die zweite Frequenz wenigstens zwei gleichzeitige Resonanzen bei einer Resonanzfrequenz gleich der Frequenz einer der Betätigungskräfte erzeugen.

**11.** Verfahren nach Anspruch 10, wobei die Betätigungskräfte auf elektrostatische Weise mit Hilfe wenigstens einer Elektrode (40, 70, 81-84) angelegt werden.

**12.** Verfahren nach Anspruch 11, bei dem man wenigstens eine erste Wechselspannung ($V_1$) und wenigstens eine zweite Wechselspannung ($V_2$, $V_3$, $V_4$, $V_n$) angelegt.

**13.** Verfahren nach Anspruch 12, wobei die erste Wechselspannung ($V_1$) bei der ersten Frequenz ist, wobei diese gleich der Resonanzfrequenz ($\omega_0$) des Resonators gewählt ist, und wobei wenigstens eine zweite Wechselspannung bei der zweiten Frequenz ist, die gleich einer subharmonischen Resonanzfrequenz ($k\omega_0$, mit k>1) oder gleich einer superharmonischen Resonanzfrequenz ($\omega_0$/k, mit k>1) des Resonators gewählt ist, vorzugsweise k = 2.

**14.** Verfahren nach Anspruch 11, bei dem man wenigstens eine erste Wechselspannung ($V_1$, $V_2$, $V_{ac}$) sowie eine zweite Gleichspannung ($V_{dc}$) anlegt.

**15.** Verfahren nach einem der Ansprüche 10 bis 14 bei dem die Summe des mechanischen Nichtlinearitätskoeffizienten und des elektrischen Nichtlinearitätskoeffizienten dritter Ordnung Null oder Nahe bei Null ist.

**Claims**

**1.** An electromechanical resonator including at least one deformable element (20, 60, 80), actuating means (42, 44, 52, 54, 42', 44', $40_1$-$40_5$, 81-84) for this deformable element
**Characterized in that** said actuating means are adapted to apply to said deformable element, simultaneously, at least one first actuating force at a first frequency, and a second actuating force at a second frequency, the first and the second forces creating at least two simultaneous resonances at a resonant frequency equal to the frequency of one of the actuating forces.

**2.** The resonator according to Claim 1, the means of actuation being of the electrostatic type, and including at least one electrode (40, 50, 51).

**3.** The resonator according to Claim 2, including means for applying to the electrostatic type actuating means (20, 70) at least one first alternating voltage ($V_1$) for generating the first actuating force and a second alternating voltage ($V_2$, $V_3$, $V_4$, $V_n$) for generating the second actuating force.

**4.** The resonator according to Claim 3, the first alternating voltage ($V_1$) being at said first frequency, this being selected to be equal to the resonant frequency ($\omega_0$) of the device, and the second alternating voltage being at said second frequency, this one being selected to be equal to a subharmonic resonant frequency ($k\omega_0$, with k>1) of the resonator, or to a superharmonic resonant frequency ($\omega_0$/k, with k>1).

**5.** The resonator according to Claim 4 in which k = 2.

**6.** The resonator according to Claim 2, including means for applying at least one first alternating voltage ($V_1$, $V_2$, $V_{ac}$) and one second, direct voltage ($V_{dc}$) to the electrostatic actuating means (20, 70).

**7.** The resonator according to one of the foregoing claims, in which the deformable element is a beam (20), embedded at one or both of its ends (20', 20"), or a membrane (60), or a plate or a substrate (80) undergoing extensional vibration.

**8.** The resonator according to Claim 7, in which the deformable element is a nanowire or a nanotube.

**9.** The resonator according to one of the foregoing claims, in which the sum of the mechanical nonlinearity coefficient and the electrical nonlinearity coefficient of order 3 is zero or nearly zero.

**10.** A method for actuating an electromechanical resonator including at least one deformable element (20, 60, 80), in which at least one first actuating force at a first frequency and a second actuating force at least one second frequency are applied simultaneously to the deformable element, the first and the second frequencies creating at least two simultaneous resonances at a resonant frequency equal to the frequency of one of the actuating forces.

**11.** The method according to Claim 10, the actuating forces being applied electrostatically using at least one electrode (40, 70, 81-84).

12. The method according to Claim 11, in which at least one first alternating voltage ($V_1$) and at least one second alternating voltage ($V_2$, $V_3$, $V_4$, $V_n$) are applied.

13. The method according to Claim 12, the first alternating voltage ($V_1$) being the said first frequency, this being selected equal to the resonant frequency ($\omega_0$) of the resonator, and at least one second alternating voltage being the said second frequency, selected equal to a subharmonic resonant frequency ($k\omega_0$, with k>1) or to a superharmonic resonant frequency ($\omega_0/k$, with k>1) of the resonator, preferably k = 2.

14. The method according to Claim 11 in which at least one first alternating voltage ($V_1$, $V_2$, $V_{ac}$) and one second, direct voltage ($V_{dc}$) are applied.

15. The method according to one of Claims 10 through 14, in which the sum of the mechanical nonlinearity coefficient and the electrical nonlinearity coefficient of order 3 is zero or nearly zero.

FIG.1

FIG.2

FIG.3

FIG.4

FIG.5

FIG.6

FIG.7

FIG.8

FIG.9

FIG.10

FIG.11

FIG.12

FIG.13

FIG.14A

FIG.14B

FIG.14C

209

208

**FIG.14D**

210

**FIG.14E**

212

214

**FIG.14F**

20

**FIG.14G**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- **V.KAAJAKARI et al.** *20 IEEE Trans. Ultrason. Ferroelectr. Freq. Control,* 2005, vol. 52, 2322-2331
- **L. C. SHAO et al.** *J. Micromech. Microeng.,* 2008, vol. 18, 065014-9
- **M. AGARWAL et al.** *IEEE International Electron Devices Meeting,* 2005
- **KOZINSKI et al.** *Appl. Phys. Lett,* 2006, vol. 88, 253101
- **N. KACEM et al.** *Nanotechnology,* 2009, vol. 20, 275501
- **N. KACEM ; S. HENTZ.** *Appl. Phys. Lett.,* 2009, vol. 95, 183104
- **V.KAAJARI et al.** Square extensional mode single-crystal micromechanical RF resonator. *Proc. Transducers 04, Int.Conf. Solid State Sens. Actuators,* 2004, 951-954
- Square extensional mode single-crystal micromechanical resonator for low phase noise oscillator applications. *IEEE Electron. Device Lett.,* 2004, vol. 25 (4), 173-175
- **KACEM et al.** *J. Micromech. Microeng.,* 2010, vol. 20
- **J.ARCAMONE et al.** Full wafer fabrication Full-wafer fabrication by nanostencil lithography of micro/nanomechanical mass sensors monolithically integrated with CMOS. *Nanotechnology,* 2008, vol. 19, 305302